# EUROPÄISCHE PATENTANMELDUNG

(11) **EP 1 710 590 A1**
(43) Veröffentlichungstag der Anmeldung: **11.10.2006**
(21) Anmeldenummer: 05007778.3
(22) Anmeldetag: 08.04.2005
(51) Int. Cl.: G01R 19/25, H02H 3/00, G01R 31/34, G01R 31/327, G01R 31/08, G01R 29/16, G01R 29/18, G01R 19/165

(54) **Verfahren zum Testen und Testsystem für energietechnische Einrichtungen**

(71) Anmelder: Omicron electronics GmbH, 6833 Klaus (AT)
(72) Erfinder: Steinhauser, Fred, Dr., 6833 Klaus (AT)
(74) Vertreter: Banzer, Hans-Jörg

(57) **Zusammenfassung**

Es wird ein Verfahren zum Testen von energietechnischen Einrichtungen (15, 16) offenbart, welches Testeinheiten (101-104) und eine zentrale Steuervorrichtung (3) zum Steuern der Testeinheiten (101-104) umfasst. Dabei werden mithilfe der Testeinheiten (101-104), welche räumlich auseinander liegen, die energietechnischen Einrichtungen (15, 16) getestet. Zur Steuerung sind die Testeinheiten (101-104) dabei direkt über ein Kommunikationsnetz (1), gegebenenfalls das Internet, mit der zentralen Steuervorrichtung (3) verbunden. Insbesondere können Hauptaufgaben der Tests der energietechnischen Einrichtungen (15, 16) durch Testmittel (201, 202) ausgeführt werden, welche innerhalb der zu testenden energietechnischen Einrichtungen (15, 16) angeordnet sind.

## Beschreibung

Die vorliegende Erfindung betrifft ein Verfahren zum Testen von energietechnischen Einrichtungen und ein entsprechend ausgestaltetes verteiltes Testsystem.

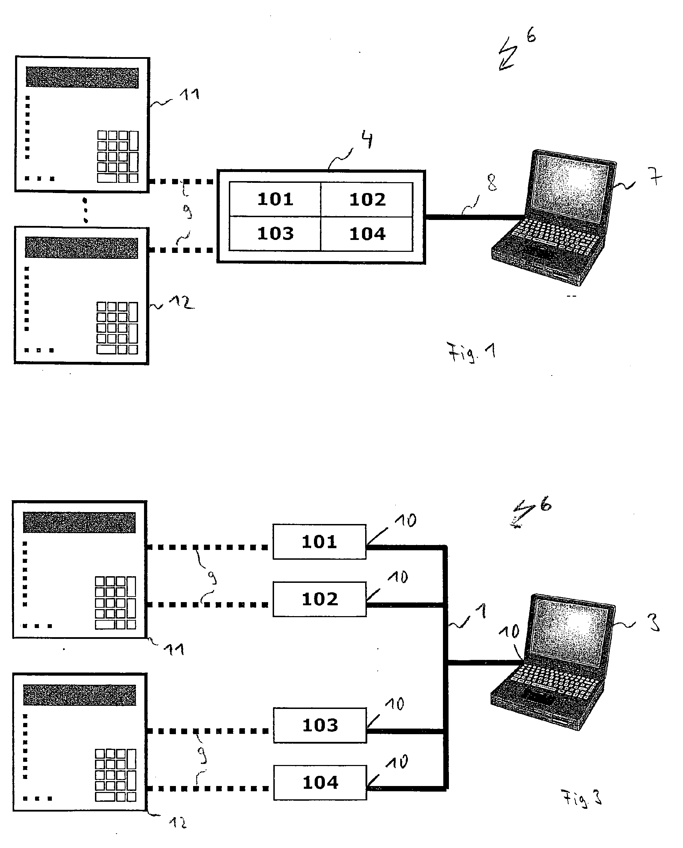

Nach dem Stand der Technik sind Testkomponenten bzw. Testeinheiten zum Testen bzw. Prüfen energietechnischer Einrichtungen in Testanordnungen integriert. Dabei sind Testeinheiten beispielsweise Generatoren für Spannungen und Ströme sowie binäre Testmuster, Zähler oder Vorrichtungen, mit welchen Gleichspannungen, Gleichströme, Wechselspannungen oder Wechselströme sowie binäre Testantworten erfasst werden können. In Fig. 1 ist ein Testsystem 6 nach dem Stand der Technik dargestellt. Es umfasst ein Prüfgerät bzw. eine Testanordnung 4, welche vier Testeinheiten 101-104 aufweist, wobei die Testanordnung 4 und damit die vier Testeinheiten 101-104 mit zwei oder mehreren energietechnischen Einrichtungen 11, 12 verbunden sind, um diese energietechnischen Einrichtungen 11, 12 zu testen. Zusätzlich umfasst das Testsystem eine lokale Steuereinrichtung, in der Regel ein tragbarer Computer 7, welcher über ein Verbindungskabel 8 mit der Testanordnung 4 verbunden ist, um einen Test aufzusetzen und zu steuern, sowie seine Ausführung zu koordinieren und schließlich die Ergebnisse des Tests abzurufen. Zur Durchführung eines Tests sind die Testeinheiten 101-104 über eine Verbindungsleitung 9 (hier handelt es sich in der Regel um mehrere Leitungen, welche nur als eine Leitung dargestellt sind) mit zwei oder mehreren zu testenden energietechnischen Einrichtungen 11, 12 verbunden. Über die Verbindungsleitung 9 werden die energietechnischen Einrichtungen 11, 12 mit Teststimuli bzw. Testmustern beaufschlagt und die entsprechenden Antworten abgeholt. Nach dem Stand der Technik kann sowohl die Verbindung zwischen der Testanordnung 4 und den energietechnischen Einrichtungen 11, 12 als auch die Verbindung 8 zwischen der Testanordnung und der lokalen Steuervorrichtung 7 Teil desselben Netzwerkes sein. Darüber hinaus können die energietechnischen Einrichtungen 11, 12, welche beispielsweise Systeme zum Schutz von elektrischen Energiesystemen oder Systeme für die Stationsleittechnik sein können, auch über weitere Verbindungen oder Verbindungsleitungen verfügen, mit welchen sie beispielsweise untereinander verbunden sind.

Als Schnittstelle für die Verbindung zwischen der lokalen Steuervorrichtung 7 und der Testanordnung 4 werden zahlreiche Typen von Schnittstellen bzw. Ports eingesetzt. Weit verbreitet sind serielle Ports (RS232), parallele Ports (Centronics, IEEE 1284, IEEE 488) oder USB-Ports. Die Verwendung von Kommunikationsnetzen, beispielsweise mit dem Ethernetprotokoll, ist auch bekannt.

Es gibt bestimmte Tests, beispielsweise die Mehrendprüfung beim Testen des Schutzes von Übertragungsleitungen oder beim Testen eines Schutzes von Sammelschienen in großen Schaltanlagen, wobei die Testmuster an einem ersten Ort aufzubringen sind und die entsprechenden Testantworten an einem zweiten Ort beobachtet werden müssen, wobei diese beiden Orte derart weit voneinander entfernt sind, dass diese Entfernung nicht mit den herkömmlichen Schnittstellen zwischen der lokalen Steuervorrichtung 7 und der Testanordnung überbrückt werden kann. In diesem Fall werden heutzutage mehrere integrierte Testanordnungen an voneinander entfernten Orten eingesetzt. Die Steuerung dieser Testanordnungen mit herkömmlichen Schnittstellen wird dabei durch Bedienpersonen durchgeführt, welche sich lokal an der jeweiligen Testanordnung befinden und dort die lokale Steuervorrichtung bedienen. Die Koordination zwischen den Bedienpersonen wird dabei durch andere Kommunikationsmittel durchgeführt, als zur Verbindung zwischen einer Testanordnung und der lokalen Steuervorrichtung eingesetzt werden, wobei heutzutage diese Kommunikationsmittel häufig noch das Telefon sind. Dieses Vorgehen kann verbessert werden, indem die lokalen Steuervorrichtungen, welche sich in der Nähe der jeweiligen Testanordnung befinden, wiederum von einer zentralen Steuervorrichtung ferngesteuert werden.

Bei all diesen Tests, bei welchen zur Durchführung Testanordnungen an voneinander entfernten Orten eingesetzt werden müssen, müssen diese Testanordnungen bezüglich der Zeit mit einer Genauigkeit synchronisiert werden, welche für den jeweiligen Test ausreichend ist. Dies ist erforderlich, um die Testmuster synchron anlegen und die gemessenen Testantworten geeignet bewerten zu können.

Für die erforderliche Zeitsynchronisation werden verschiedene Verfahren verwendet, wobei sich die meisten mehr oder weniger direkt auf eine von Satelliten synchronisierte Zeit abstützen. Dabei gibt es zum einen ein Verfahren, bei welchem jede Testanordnung die Zeit direkt von einem Satelliten empfängt (beispielsweise mithilfe von GPS) oder zum anderen ein Verfahren, bei welchem die Testanordnungen ihre Zeit von einem zur Zeitverteilung ausgelegten Netzwerk (z.B. IRIG-B, NTP usw.) erhalten, welches selbst wiederum die Zeit von Satelliten empfängt. Des Weiteren gibt es die Möglichkeit, dass stabile Taktsysteme innerhalb der getrennt angeordneten Testanordnungen eingesetzt werden, welche vorab synchronisiert werden und dann die für einen bestimmten Test geforderte Genauigkeit aufweisen, auch wenn sie über eine gewisse Zeitspanne hinweg unsynchronisiert laufen.

Es ist eine Aufgabe der vorliegenden Erfindung, ein Verfahren zum Testen energietechnischer Einrichtungen und einen entsprechend ausgestaltetes Testsystem bereitzustellen, wodurch das Testen energietechnischer Einrichtungen im Vergleich zum Stand der Technik einfacher wird.

Diese Aufgabe wird durch ein Verfahren zum Testen von energietechnischen Einrichtungen nach Anspruch 1 und ein Testsystem zum Testen von energietechnischen Einrichtungen nach Anspruch 12 gelöst. Die abhängigen Ansprüche definieren bevorzugte und vorteilhafte Ausführungsformen der Erfindung.

Im Rahmen der vorliegenden Erfindung wird ein Verfahren zum Testen von energietechnischen Einrichtungen bereitgestellt, wobei mehrere Testeinheiten in räumlich auseinander liegenden Standorten angeordnet werden. Dabei ist jede Testeinheit mit mindestens einer dieser energietechnischen Einrichtungen gekoppelt, um einen Teil einer Prüfung an dieser energietechnischen Einrichtung durchzuführen. Zur Steuerung der Testeinheiten werden zentrale Steuermittel direkt über ein Kommunikationsnetz mit den Testeinheiten gekoppelt.

Dabei wird unter einer direkten Kopplung zwischen Vorrichtungen (im obigen Fall eine direkte Kopplung der zentralen Steuermittel und den Testeinheiten) über ein Kommunikationsnetz in diesem Dokument eine Kopplung verstanden, bei welcher zwischen den Vorrichtungen nur dann weitere Vorrichtungen angeordnet sind, wenn diese zum Betrieb des Kommunikationsnetzes benötigt werden, wie beispielsweise Router oder Switche, aber z.B. keine lokale Steuervorrichtung zu Testzwecken dazwischen vorhanden ist.

Es sei darauf hingewiesen, dass bei dem erfindungsgemäßen Verfahren mehrere der Testeinheiten räumlich weit (> 100km) auseinander angeordnet werden, um dieselbe energietechnische Einrichtung zu testen, wenn die zu testende energietechnische Einrichtung entsprechende Abmessungen aufweist.

Da die Testeinheiten direkt mit den zentralen Steuermitteln, beispielsweise einem oder mehreren PC(s) und/oder einem oder mehreren tragbaren Computern gekoppelt werden, kann das Verfahren zum Testen von energietechnischen Einrichtungen im Vergleich zum Stand der Technik, bei welcher zwischen den zentralen Steuermitteln und den Testeinheiten noch eine lokale Steuerung angeordnet ist, einfacher durchgeführt werden, da während einer Testdurchführung weniger Komponenten (nämlich nicht die lokale Steuerung) betrachtet werden müssen. Dabei sei noch angemerkt, dass ein einfacheres Testverfahren auch robuster und damit weniger störungsanfällig ist.

Erfindungsgemäß können dabei einige der Testeinheiten, welche zur Durchführung eines Tests einer energietechnischen Einrichtung koordiniert werden müssen, zeitlich synchronisiert werden. Insbesondere können diese zu koordinierenden Testeinheiten zu einer Testanordnung zusammengefasst werden. Eine solche Testanordnung kann dann über das Kommunikationsnetz mit anderen Testeinheiten außerhalb der entsprechenden Testanordnung, mit anderen Testanordnungen und den zentralen Steuermitteln direkt gekoppelt werden.

Indem mehrere Testeinheiten zu einer Testanordnung zusammengefasst werden, wird die Aufgabe beim Testen für die zentralen Steuermittel im Vergleich zu dem Fall, dass die Testeinheiten nicht zu einer Testanordnung zusammengefasst werden, dahingehend erleichtert, dass die Steuermittel nur noch über das Kommunikationsnetz mit der Testanordnung zu kommunizieren haben, wenn sie eine der Testeinheiten der Testanordnung ansprechen wollen..

Bei einer bevorzugten erfindungsgemäßen Ausführungsform werden Testmittel innerhalb einer energietechnischen Einrichtung über das Kommunikationsnetz direkt mit den zentralen Steuermitteln und mit den Testeinheiten gekoppelt. Dabei sind die Testmittel derart ausgelegt, dass sie ein Testen der energietechnischen Einrichtung, in welcher sie angeordnet sind, unterstützen oder durchführen. Dabei können die Testmittel eine oder mehrere Testeinheiten sein, welche innerhalb der von ihnen zu testenden energietechnischen Einrichtung angeordnet und speziell zum Testen dieser energietechnischen Einrichtung ausgestaltet sind.

Durch die Testmittel wird das Testen der mit Testmitteln ausgestalteten energietechnischen Einrichtungen weiter vereinfacht beziehungsweise verbessert, da beispielsweise Auswirkungen einer Verbindung zwischen einer Testeinheit und der zu testenden energietechnischen Einrichtung (z.B. Laufzeit) nicht mehr berücksichtigt werden müssen.

Im Rahmen der vorliegenden Erfindung wird auch ein Testsystem zum Testen von energietechnischen Einrichtungen bereitgestellt, welches mehrere Testeinheiten und zentrale Steuermittel zum Steuern der Testeinheiten umfasst. Dabei ist jede der Testeinheiten, welche räumlich auseinander liegen, mit mindestens einer der energietechnischen Einrichtungen gekoppelt, um einen Teil einer Prüfung an dieser energietechnischen Einrichtung durchzuführen. Die zentralen Steuermittel und die Testeinheiten weisen dabei jeweils eine Kommunikationsschnittstelle auf, über welche die Testeinheiten und die zentralen Steuermittel über ein Kommunikationsnetz direkt miteinander koppelbar sind.

Die Vorteile des erfindungsgemäßen Testsystems entsprechen denjenigen, welche bereits vorab bei der Diskussion des erfindungsgemäßen Verfahrens zum Testen von energietechnischen Einrichtungen beschrieben worden sind, weshalb auf eine Wiederholung hier verzichtet wird.

Die vorliegende Erfindung eignet sich insbesondere zur Durchführung von Tests von Systemen zum Schutz von elektrischen Energiesystemen oder von Systemen für eine Stationsleittechnik. Selbstverständlich ist die vorliegende Erfindung jedoch nicht auf diesen bevorzugten Anwendungsbereich beschränkt, sondern kann bei allen möglichen Arten von energietechnischen Einrichtungen eingesetzt werden.

Die vorliegende Erfindung wird nachfolgend näher unter Bezugnahme auf die beigefügte Zeichnung anhand bevorzugter Ausführungsformen erläutert.
Fig. 1 stellt ein Testsystem nach dem Stand der Technik dar.
Fig. 2 stellt eine erste Ausführungsform eines erfindungsgemäßen Testsystems mit zwei Testanordnungen dar.
Fig. 3 stellt eine zweite Ausführungsform eines erfindungsgemäßen Testsystems mit vier Testeinheiten dar.
Fig. 4 stellt eine dritte Ausführungsform eines erfindungsgemäßen Testsystems mit vier Testeinheiten und zwei Testmitteln dar.
Fig. 5 stellt eine vierte Ausführungsform eines erfindungsgemäßen Testsystems mit einer Testanordnung und zwei Testmitteln dar.

Einleitend sei darauf hingewiesen, dass die energietechnischen Einrichtungen 11-16 in den folgenden erfindungsgemäßen Ausführungsformen Systeme zum Schutz eines elektrischen Energiesystems oder Systeme für die Stationsleittechnik sind, wenn nicht explizit etwas anderes beschrieben ist. Dabei prüft ein erfindungsgemäßes Testsystem 6 die energietechnische Einrichtung 11-16, indem es einen Zustand (Gutzustand oder meist Fehlerzustand) dieser energietechnischen Einrichtung 11-16 einstellt und dann bewertet, wie die energietechnische Einrichtung 11-16 auf den Zustand reagiert.

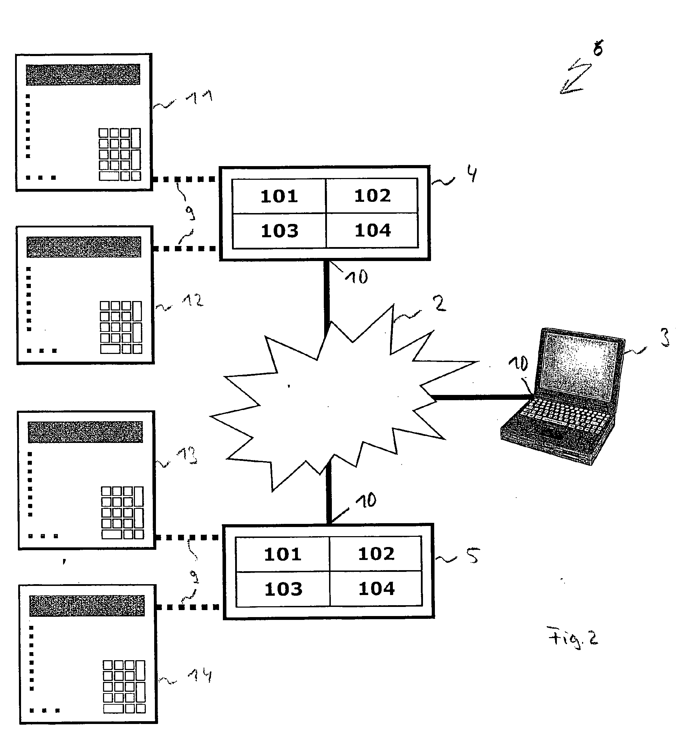

Des Weiteren sei angemerkt, dass, obwohl in den Figuren 2-5 nur zwei oder vier energietechnische Einrichtungen dargestellt sind, die Erfindung auch eingesetzt werden kann, um mehr als vier energietechnische Einrichtungen zu prüfen bzw. zu testen. Weiterhin sei darauf hingewiesen, dass es sich bei der als gestrichelte Linie dargestellten Verbindung 9 zwischen einer Testanordnung oder Testeinheit und einer energietechnischen Einrichtung in der Regel um mehrere Verbindungen handelt. In ähnlicher Weise ist die Anzahl von vier Testeinheiten nicht einschränkend zu verstehen. Selbstverständlich können auch mehrere Testeinheiten vorhanden sein.

In Fig. 2 ist ein erfindungsgemäßes Testsystem 6 dargestellt, welches neben einem tragbaren Computer 3 als zentrales Steuermittel zwei Testanordnungen 4, 5 zum Testen von vier energietechnischen Einrichtungen 11-14 aufweist. Dabei umfasst jede Testanordnung 4, 5 vier Testeinheiten 101-104, das heißt, die vier Testeinheiten 101-104 sind jeweils in der Testanordnung 4 bzw. 5 integriert. Während die Testanordnung 4 über jeweils eine Verbindungsleitung 9 mit den energietechnischen Einrichtungen 11, 12 verbunden ist, ist die Testanordnung 5 über jeweils eine Verbindungsleitung 9 mit den energietechnischen Einrichtungen 13, 14 verbunden. Zur Durchführung von Tests der energietechnischen Einrichtungen 11-14 werden die beiden Testanordnungen 4, 5 über ein WAN (Weitverkehrsnetz) von dem tragbaren Computer 3 zentral gesteuert. Dabei sei explizit darauf hingewiesen, dass zur Steuerung der Testanordnungen 4, 5 keine weitere beispielsweise lokale Steuervorrichtung, welche am Ort der jeweiligen Testanordnung 4, 5 angeordnet ist, notwendig ist. Damit die Testanordnungen 4, 5 mit dem WAN und damit mit dem tragbaren Computer 3 koppelbar sind, besitzen die Testanordnungen 4, 5 jeweils eine Netzwerkschnittstelle 10, beispielsweise ein CMC 256 mit NET-1-Option.

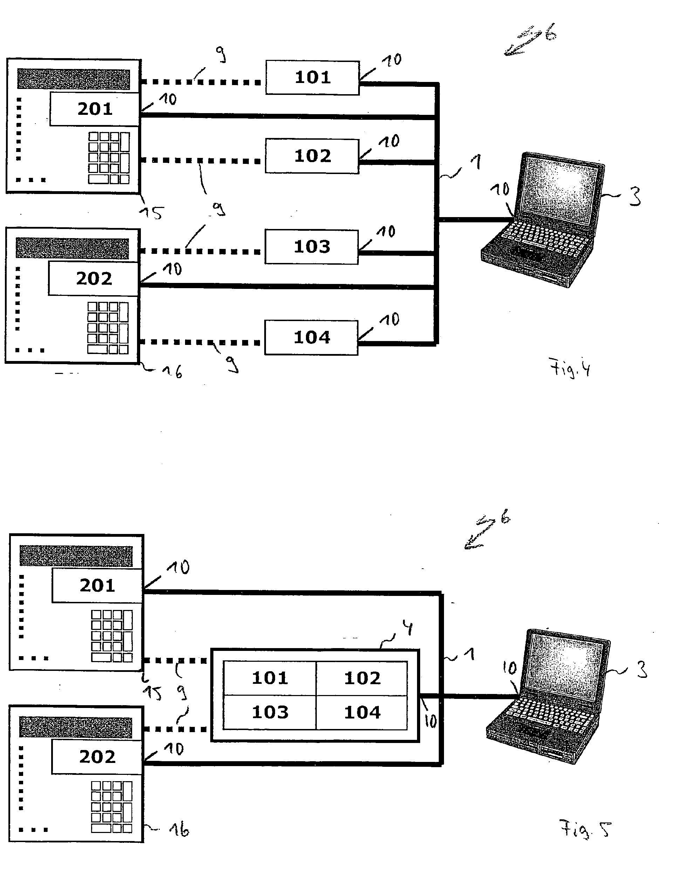

Fig. 3 stellt eine zweite erfindungsgemäße Ausführungsform dar, bei welcher die vier Testeinheiten 101-104, welche bei der in Fig. 2 dargestellten Ausführungsform in einer Testanordnung 4, 5 integriert sind, getrennt implementiert sind. Dabei weist jede Testeinheit 101-104 eine Netzwerkschnittstelle 10 auf, um über ein Kommunikationsnetz 1 mit dem tragbaren Computer 3 verbunden zu sein, welches die Testeinheiten 101-104 direkt, das heißt ohne weitere Steuereinrichtung, steuert. Jede Testeinheit 101-104 besitzt eine individuelle Verbindung 9 mit der zu testenden energietechnischen Einrichtung 11, 12, wobei die jeweilige Verbindung entsprechend eines Einsatzes bzw. einer Funktion der jeweiligen Testeinheit 101-104 ausgestaltet ist. Dabei sind die Hauptfunktionen der Testeinheiten 101-104 ein Erzeugen von Testmustern oder ein Aufnehmen und Auswerten von Testantworten.

Da alle Testeinheiten 101-104 mit dem Kommunikationsnetz 1 verbunden sind, stehen sie auch untereinander in Kontakt, um sich untereinander koordinieren zu können. Die Testeinheiten 101-104 sind Zeit synchronisiert und bilden zusammen mit der zentralen Steuervorrichtung 3 ein verteiltes Testsystem 6, um koordinierte Tests auszuführen. Da die energietechnischen Einrichtungen 11, 12 örtlich getrennt sind, sind auch die Testeinheiten 101, 102 und die Testeinheiten 103, 104 örtlich getrennt.

In Fig. 4 ist eine dritte erfindungsgemäße Ausführungsform dargestellt, bei welcher das Testsystem 6 im Vergleich zur in Fig. 3 dargestellten Ausführungsform zwei Testmittel bzw. Testkomponenten 201, 202 der zu testenden energietechnischen Einrichtungen 15, 16 umfasst. Diese Testkomponenten 201, 202 weisen jeweils eine Netzwerkschnittstelle 10 auf, so dass sie über das Kommunikationsnetz 1 sowohl mit der zentralen Steuervorrichtung, dem tragbaren Computer 3, als auch mit den Testeinheiten 101-104 sowie mit der jeweils anderen Testkomponente 202, 201 verbindbar sind. Aus dem Blickwinkel der zentralen Steuervorrichtung 3 gibt es bezüglich einer Ansteuerung keinen Unterschied zwischen den Testkomponenten 201, 202 und den Testeinheiten 101-104. Die Netzwerkschnittstelle 10 der jeweiligen Testkomponente 201, 202 ist dabei die Netzwerkschnittstelle 10 der energietechnischen Einrichtung 15, 16, in welcher die jeweilige Testkomponente 201, 202 angeordnet ist.

Die Funktion der Testkomponenten 201, 202 ist, bestimmte Störschriebe oder Fehlerszenarien der entsprechenden energietechnischen Einrichtung 15, 16 aufzuzeichnen und wiederzugeben. Wenn eine Testkomponente beispielsweise in einer Merging Unit angeordnet ist, ist die Funktion der Testkomponente, Störschriebe wiederzugeben. Dabei ist eine Merging U-nit eine Vorrichtung, welche Daten von Energieprozessen, beispielsweise von Strömen und Spannungen, sammelt und diese Daten in digitaler Form zur Verfügung stellt. Unter einem Störschrieb wird eine Art Protokoll mit einem zeitlich sehr engen Raster verstanden, wobei beispielsweise Verläufe von Strömen und Spannungen aber auch Meldungen von Vorrichtungen aufgezeichnet werden. Bei einer Testkomponente in einem Schutzrelay werden GOOSE-Meldungen (Generic Object Oriented Substation Event), d.h. ereignisgetriebene Meldungen, aufgezeichnet und wiedergegeben.

In Fig. 5 ist eine vierte erfindungsgemäße Ausführungsform des Testsystems 6 dargestellt, welches neben den Testkomponenten 201, 202 die Testanordnung 4 und die zentrale Steuervorrichtung beziehungsweise den tragbaren Computer 3 umfasst. Über das Kommunikationsnetz 1 sind die Testkomponenten 201, 202, die Testanordnung 4 und der tragbare Computer 3 miteinander verbunden. Dabei sind die Testkomponenten 201, 202, wie bei der in der Fig. 4 dargestellten Ausführungsform, jeweils in den zu testenden energietechnischen Einrichtungen 15, 16 angeordnet, welche sich wie bei den vorher dargestellten Ausführungsformen in lokal weit auseinander liegenden Örtlichkeiten befinden.

Bei dem in Fig. 5 dargestellten Testsystem 6 werden die meisten bei einem Test der energietechnischen Einrichtungen 15, 16 durchzuführenden Aufgaben durch die Testkomponenten 201, 202 durchgeführt, wobei die Testkomponenten 201, 202 zentral von dem tragbaren Computer 3 gesteuert werden. Nur diejenigen Aufgaben bei dem Test der energietechnischen Einrichtungen 15, 16, welche nicht durch die Testkomponenten 201, 202 durchgeführt werden können, werden durch die Testanordnung 4, welche die vier Testeinheiten 101-104 integriert, durchgeführt, wozu die Testanordnung 4 mit Verbindungsleitungen 9 mit den energietechnischen Einrichtungen 15, 16 verbunden ist.

Wenn bei der mit Fig. 5 diskutierten Ausführungsform der Abstand zwischen den energietechnischen Einrichtungen 15, 16 sehr groß ist (beispielsweise > 100km), ist die Testanordnung 4 zum Testen entweder nur an einer der beiden energietechnischen Einrichtungen 15, 16 angeschlossenen oder es gibt zwei Testanordnungen 4, wobei jeweils eine an einer der energietechnischen Einrichtungen 15, 16 angeschlossen ist. Im Fall dass nur eine Testanordnung 4 an einer energietechnischen Einrichtung 15, 16 angeschlossen ist, werden die Funktionen der Testanordnung 4 bei welcher die Testanordnung 4 nicht angeschlossen ist, dann durch die entsprechende Testkomponente 201, 202 übernommen.

Schließlich sei darauf hingewiesen, dass es erfindungsgemäß auch eine nicht dargestellte Ausführungsform gibt, bei welcher das Testsystem keine außerhalb der zu testenden energietechnischen Einrichtungen 15, 16 angeordneten Testanordnungen oder Testeinheiten umfasst, so dass das Testsystem in diesem Fall nur aus innerhalb der zu testenden energietechnischen Einrichtungen liegenden Testkomponenten und der zentralen Steuervorrichtung besteht, welche über ein Kommunikationsnetz, gegebenenfalls das Internet, gekoppelt sind.

## Patentansprüche

1. Verfahren zum Testen von energietechnischen Einrichtungen (11-16), wobei mehrere Testeinheiten (101-104), welche zum Testen der energietechnischen Einrichtungen (11-16) jeweils mit mindestens einer der energietechnischen Einrichtungen (11-16) gekoppelt werden, in räumlich auseinander liegenden Standorten angeordnet werden,
**dadurch gekennzeichnet,**
**dass** zentrale Steuermittel (3) zum Steuern der Testeinheiten (101-104) mit den Testeinheiten (101-104) über ein Kommunikationsnetz (1; 2) direkt miteinander gekoppelt werden.

2. Verfahren nach Anspruch 1,
**dadurch gekennzeichnet,**
**dass** jede Testeinheit (101-104) die mindestens eine energietechnische Einrichtung (11-16), mit welcher sie gekoppelt wird, mit Testdaten beaufschlagt und/oder Messdaten der mindestens einen energietechnischen Einrichtung (11-16) erfasst.

3. Verfahren nach Anspruch 1 oder 2,
**dadurch gekennzeichnet,**
**dass** einige der Testeinheiten (101-104), welche zur koordinierten Durchführung eines Tests einer der energietechnischen Einrichtungen (11-16) notwendig sind, zeitlich synchronisiert werden.

4. Verfahren nach einem der vorhergehenden Ansprüche,
**dadurch gekennzeichnet,**
**dass** einige der Testeinheiten (101-104), welche zur koordinierten Durchführung eines Tests einer der energietechnischen Einrichtungen (11-16) notwendig sind, zu einer Testanordnung (4; 5) zusammengefasst werden,
**dass** jede Testanordnung (4; 5) über das Kommunikationsnetz (1; 2) mit anderen Testeinheiten (101-104) außerhalb der entsprechenden Testanordnung (4; 5) und den zentralen Steuermitteln (3) direkt gekoppelt werden.

5. Verfahren nach einem der vorhergehenden Ansprüche,
**dadurch gekennzeichnet,**
**dass** Testmittel (201; 202) innerhalb mindestens einer der energietechnischen Einrichtungen (15; 16) über das Kommunikationsnetz (1; 2) mit den Testeinheiten (101-104) und den zentralen Steuermitteln (3) direkt gekoppelt werden, und dass mit Hilfe der Testmittel (201; 202) die mindestens eine der energietechnischen Einrichtungen (15; 16) getestet wird.

6. Verfahren nach Anspruch 5,
**dadurch gekennzeichnet,**
**dass** mit den Testmitteln (201; 202) mindestens eine Funktion ausgeführt werden, welche ausgewählt sind aus einer Gruppe umfassend:
- eine der energietechnischen Einrichtungen (15; 16) wird mit Testdaten beaufschlagt,
- Messdaten der mindestens einen energietechnischen Einrichtung (15; 16) werden erfasst,
- ein Störschrieb wird aufgezeichnet und/oder wiedergegeben,
- bestimmte Ereignisse innerhalb der mindestens einen energietechnischen Einrichtung (15; 16) werden aufgezeichnet und wiedergegeben,
- eine ereignisgetriebene Meldung wird aufgezeichnet, wiedergegeben und/oder erzeugt.

7. Verfahren nach Anspruch 5 oder 6,
**dadurch gekennzeichnet,**
**dass** eins der Testmittel eine der Testeinheiten ist.

8. Verfahren nach einem der Ansprüche 5-7,
**dadurch gekennzeichnet,**
**dass** zum Testen der energietechnischen Einrichtungen (11-16) nur die Testmittel (201; 202) und die zentralen Steuermittel (3) verwendet werden.

9. Verfahren nach einem der vorhergehenden Ansprüche,
**dadurch gekennzeichnet,**
**dass** das Kommunikationsnetz das Internet (1) und/oder ein Intranet (2) umfasst.

10. Verfahren nach einem der vorhergehenden Ansprüche,
**dadurch gekennzeichnet,**
**dass** die Steuermittel ein PC oder ein tragbarer Computer (3) sind.

11. Verfahren nach einem der vorhergehenden Ansprüche,
**dadurch gekennzeichnet,**
**dass** die Steuermittel mehrere PCs und/oder tragbare Computer (3) umfassen.

12. Testsystem zum Testen von energietechnischen Einrichtungen (11-16), welches mehrere Testeinheiten (101-104), welche zum Testen der energietechnischen Einrichtungen (11-16) jeweils mit mindestens einer der energietechnischen Einrichtungen (11-16) zu koppeln sind, in räumlich auseinander liegenden Standorten umfasst,
**dadurch gekennzeichnet,**
**dass** das Testsystem (6) zusätzlich zentrale Steuermittel (3) zum Steuern der Testeinheiten (101-104) umfasst, und
**dass** sowohl die zentralen Steuermittel (3) als auch die Testeinheiten (101-104) jeweils eine Kommunikationsschnittstelle (10) aufweisen, so dass die Testeinheiten (101-104) und die zentralen Steuermittel (3) über die jeweiligen Kommunikationsschnittstellen (10) über ein Kommunikationsnetz (1; 2) direkt miteinander koppelbar sind.

13. Testsystem nach Anspruch 12,
**dadurch gekennzeichnet,**
**dass** jede Testeinheit (101-104) derart ausgestaltet ist, dass sie die mindestens eine energietechnische Einrichtung (11-16), mit welcher sie zu koppeln ist, mit Testdaten beaufschlagt und/oder Messdaten der mindestens einen energietechnischen Einrichtung (11-16) erfasst.

14. Testsystem nach Anspruch 12 oder 13,
**dadurch gekennzeichnet,**
**dass** das Testsystem (6) derart ausgestaltet ist,
**dass** einige der Testeinheiten (101-104), welche zur koordinierten Durchführung eines Tests einer der energietechnischen Einrichtungen (11-16) notwendig sind, zeitlich synchronisiert sind.

15. Testsystem nach einem der Ansprüche 11-14,
**dadurch gekennzeichnet,**
**dass** einige der Testeinheiten (101-104), welche zur koordinierten Durchführung eines Tests einer der energietechnischen Einrichtungen (11-16) notwendig sind, zu einer Testanordnung (4; 5) zusammengefasst sind,
**dass** jede Testanordnung (4; 5) eine Kommunikationsschnittstelle (10) aufweist, wobei jede Testeinheit (101-104) der entsprechenden Testanordnung (4; 5) über diese Kommunikationsschnittstelle (10) über das Kommunikationsnetz (1; 2) mit anderen Testeinheiten (101-104) außerhalb der entsprechenden Testanordnung (4; 5) und den zentralen Steuermitteln (3) direkt koppelbar ist.

16. Testsystem nach einem der Ansprüche 12-15,
**dadurch gekennzeichnet,**
**dass** das Testsystem (6) Testmittel (201; 202) innerhalb mindestens einer der energietechnischen Einrichtungen (15; 16) umfasst, um die mindestens eine der energietechnischen Einrichtungen (15; 16) zu testen,
**dass** die Testmittel (201; 202) eine Kommunikationsschnittstelle (10) aufweisen, über welche sie über das Kommunikationsnetz (1; 2) mit den Testeinheiten (101-104) und den zentralen Steuermitteln (3) direkt koppelbar sind.

17. Testsystem nach Anspruch 16,
**dadurch gekennzeichnet,**
**dass** die Testmittel (201; 202) zur Durchführung mindestens einer Funktion ausgestaltet sind, welche ausgewählt sind aus einer Gruppe umfassend:
- eine der energietechnischen Einrichtungen (15; 16) mit Testdaten beaufschlagen,
- Messdaten der mindestens einen energietechnischen Einrichtung (15; 16) erfassen,
- Aufzeichnen und/oder Wiedergeben eines Störschriebs,
- Aufzeichnen und Wiedergeben bestimmter Ereignisse innerhalb der mindestens einen energietechnischen Einrichtung (15; 16), Aufzeichnen, Wiedergeben und/oder Erzeugen einer ereignisgetriebenen Meldung.

18. Testsystem nach Anspruch 16 oder 17,
**dadurch gekennzeichnet,**
**dass** eins der Testmittel eine der Testeinheiten ist.

19. Testsystem nach einem der Ansprüche 16-18,
**dadurch gekennzeichnet,**
**dass** das Testsystem (6) nur die Testmittel (201; 202) und die zentralen Steuermittel (3) umfasst.

20. Testsystem nach einem der Ansprüche 12-19,
**dadurch gekennzeichnet,**
**dass** das Kommunikationsnetz das Internet (1) und/oder ein Intranet (2) umfasst.

21. Testsystem nach einem der Ansprüche 12-20,
**dadurch gekennzeichnet,**
**dass** die Steuermittel ein PC oder ein tragbarer Computer (3) sind.

22. Testsystem nach einem der Ansprüche 12-21,
**dadurch gekennzeichnet,**
**dass** die Steuermittel mehrere PCs und/oder tragbare Computer (3) umfassen.

23. Testsystem nach einem der Ansprüche 12-22, welches zur Durchführung des Verfahrens nach einem der Ansprüche 1-11 ausgestaltet ist.
